# EUROPEAN PATENT APPLICATION

(11) **EP 1 811 666 A1**
(43) Date of publication of application: **25.07.2007**
(21) Application number: 06001149.1
(22) Date of filing: 19.01.2006
(51) Int. Cl.: H03K 17/955

(54) **Proximity sensor and method for manufacturing the same**

(71) Applicant: 3M Innovative Properties Company, St. Paul, Minnesota 55133-3427 (US)
(72) Inventor: Douglas, Malcom, Swansea SA3 2DP Wales (GB)
(74) Representative: Wilhelm, Stefan

(57) **Abstract**

The present invention relates to a capacitive sensor film (50) for mounting to a body having a rear major surface (51), a front major surface (52) and an edge (53), said filmcomprising a backing layer (2) having a rear major surface (2a) facing, in use, the body and a front major surface (2b) opposite to said rear major surface (2a), said rear major surface (2a) bearing a guard conductor (1) and said front major surface (2b) bearing a sensor conductor (7) wherein electrical contact can be made to the sensor conductor (7) and to the guard conductor (1) from one of the major surfaces (51, 52) of the capacitive sensor film (50) or, at the edge (53) of the capacitive sensor film (50) or at the edge (2c) of the backing layer (2), respectively.

## Description

### Field of the invention

The present invention relates to a capacitive sensor film for mounting to a body such as, for example, the rear side and/or bumper of a vehicle. The present invention also relates to an improved method for manufacturing such capacitive sensor films.

### Background of the invention

Capacitive proximity sensors have been used in various industrial applications for locating the presence of materials and for avoiding collisions with articles. In one field of application, capacitive proximity sensors have been fitted, for example, with the rear side and/or bumpers of cars. When the vehicle is reversed a warning signal is provided when the car approaches an object so that a collision can be safely avoided while still allowing the driver to conveniently position the car close to such object.

GB 2,400,666 discloses a capacitive proximity sensor comprising a substrate bearing two metal plates on its opposite major surfaces. The capacitive proximity sensor can be provided inside the bumper of a vehicle. The metal plate facing outwardly is referred to as the sensor conductor whereas the metal plate facing the car body is called the guard conductor. The sensor conductor is screen-printed with conductive ink onto the substrate whereas the guard conductor may be a metal strip. The guard conductor is typically larger than the sensor conductor and provides a shield between the sensor conductor and the car body. The change of the capacitance between the sensor conductor and ground is monitored and provides an indication for the distance between the car and the object.

Controlling devices for capacitive sensors are disclosed, for example, in GB 2,396,015 and in WO 02/19,524.

GB 2,374,422 addresses the problem of reducing the effect of the presence of water as caused, for example, by steady rain on the sensitivity of the capacitive proximity sensor. In one embodiment it is suggested to arrange an extra conductive plate on the major side of the substrate bearing the sensor conductor. The extra conductive plate which can be arranged on the sensor conductor side above or below said sensor conductor or both (with respect to the level of the street) is often referred to as superguard conductor. In operation, an amplified guard signal is applied to the superguard conductor which has the effect of making the guard appear bigger. The superguard conductor is effective in attenuating or minimizing capacitance changes resulting from drips of water running across the front of the sensor. A capacitive proximity sensor comprising a superguard conductor is also disclosed in GB 2,404,443.

GB 2,348,505 discloses a sensor conductor geometry where the end regions of such conductor may be wider than its central position. This tends to improve the sensitivity of the capacitive proximity sensor at the corners of the vehicle.

GB 2,386,958 discloses an integral capacitive sensor for proximity detection which is integrally moulded into either the back face or the middle of the bumper of a car.

US 5,801,340 discloses a capacitive sensor for detecting the pressure of an object in a sensing region which has a relatively complicated construction and comprises, in the sequence given, a conductive ground plate, an insulator, a conductivity guard layer, an insulator and a conductive touch or sensing plate followed by another insulator.

US 2002/0,158,582 discloses a capacitive sensor for automotive applications comprising an essentially non-conductive protective screen, an electrically insulating film situated behind said protective screen and having two faces each of which is coated at least in part with an electrically conductive material.

The capacitive sensors discussed so far do not meet all practical requirements to a sufficient degree. Electrical contact is typically made to the conductor plates on the opposite surfaces of the substrate from both sides of the capacitive sensor device which renders the incorporation of the sensor device, for example, into the bumper of a car more complicated and adversely affects the reliability of the sensor device during its lifetime. The methods of manufacturing capacitive proximity sensors disclosed in the prior art include, for example, screen-printing or coating of the conductor plates which is expensive and hence does not meet the requirements of mass production. Other conventional capacitive proximity sensor constructions require a mechanical anchoring which may add costs and is less desirable from a processing point of view.

Accordingly, it is an object of the present invention to provide a capacitive proximity sensor device which does not exhibit the shortcomings of the state-of-the-art devices or exhibits them to a lower degree only, respectively. It is another object of the present invention to provide a capacitive sensor device which can be electrically contacted easily and reliably. It is still another object of the present invention to provide a method of manufacturing capacitive proximity sensors which is improved in comparison to state-of-the-art methods and complies with the requirements of mass production. Other objects of the present invention can readily be taken from the following detailed description of the invention.

### Summary of the invention

The present invention relates to a capacitive sensor film for mounting to a body having a rear major surface, a front major surface and an edge, said filmcomprising a backing layer having a rear major surface facing, in use, the body and a front major surface opposite to said rear major surface, said rear major surface bearing a guard conductor and said front major surface bearing a sensor conductor wherein electrical contact can be made to the sensor conductor and to the guard conductor from one of the major surfaces of the capacitive sensor film or, at the edge of the capacitive sensor film or at the edge of the backing layer, respectively.

In a preferred embodiment the capacitive sensor film of the present invention comprises at least one through-going hole extending through the backing layer to one of the major surfaces of the capacitive sensor film.

In another preferred embodiment the sensor conductor comprises at least one area and the guard conductor comprises at least one area, said areas being adjacent to the edge of the backing layer or the edge of the laminate, and adjacent to each other.

The present invention furthermore relates to a method comprising
(i) providing a backing layer (2) comprising a rear major surface (2a) and a front major surface (2b),
(ii) applying a guard conductor (1) to the rear major surface (2a) of the backing layer (2),
(iii) applying a sensor conductor (7) to the front major surface (2b) of the backing layer (2),
(iv) providing one or more through-going hole or holes (10) extending through the backing layer (2) so that the guard conductor (1), the sensor conductor (7) and optionally the superguard conductor (5) can be electrically contacted from one major surface (51, 52) of the laminate.

The present invention furthermore relates to the use of the capacitive sensor film of the present invention for automotive applications.

### Brief description of the figures

*Fig. 1* shows a top view of the front major surface of the backing layer 2 of a precursor of a capacitive sensor film 50 of the present invention.
*Fig. 2* shows a cross-sectional view of the precursor filmof Fig. 1 along line A-A indicated in Fig. 1.
*Fig. 3* is a top view the cross-sectional view of the capacitive sensor film 50 of the present invention comprising two through-going holes 10.
*Fig. 4* is a top view of the capacitive sensor film of Fig. 3 additionally comprising an electrically insulating film 11 covering the through-going holes 10.
*Fig*. *5* is a top view of the capacitive sensor film 50 of Fig. 4 comprising two additional auxiliary conductors 12, 13 being electrically connected to the sensor conductor 7 and the superguard conductor 5, respectively, and extending into the area of said through-going holes.
*Fig. 6* is a cross-sectional view of the capacitive sensor film 50 of Fig. 5 along line B-B indicated in Fig. 5.
*Fig. 7* is the cross-sectional view of the capacitive sensor film 50 of Fig. 5 additionally comprising two protective layers 16 and 17.
*Fig. 8* is the cross-sectional view of the capacitive sensor film of Figs. 5 with a socket 31 being applied to the rear major surface 51 of the film 50.
*Fig. 9* shows a top view of a capacitive sensor film 50 of the present invention comprising a socket 31 arranged at the edge 53 of said capacitive sensor film 50.
*Fig, 10* is a cross-sectional view of the capacitive sensor film 50 of Fig. 9 along line C-C indicated in Fig. 9.
*Fig. 11* is a cross-sectional view of the capacitive sensor film 50 of Fig. 9 along line D-D indicated in Fig. 9.

### Detailed description of the invention

The term film as used above and below refers to an article having an extension in two directions which exceed the extension in a third direction which is essential normal to said two directions by a factor of at least 5 and more preferably by at least 10. The term film as used above and below includes sheetings, foils, strips, laminates, ribbons and the like.

The term electrically isolating as used above and below refers to materials having a specific bulk resistivity as measured according to ASTM D 257 of at least 1 x 10^12 Ωcm and more preferably of at least 1 x 10^13 Ωcm. The term electrically conductive as used above and below refers to materials having a surface resistivity as measured according to ASTM B193-01 of less than 1 Ω/cm²..

The capacitive sensor film 50 of the present invention comprises an electrically isolating backing layer 2 bearing on one of its major surfaces a guard conductor 1 and on its opposite major surface a sensor conductor 7.

The backing layer is preferably continuous and preferably has a thickness of between 20 - 500 µm, more preferably of between 25 - 350 µm and especially preferably of between 25 - 150 µm. Suitable backing materials include, e. g., polymeric films and layers, paper films and layers, layers of non-wovens, laminates (such as, for example, polyacrylate foams laminated on both sides with polyolefin films, and papers laminated or jig-welded with polyethylene terephthalate) and combinations thereof. Useful polymeric films and layers include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyvinylchloride, copolymers having a predominant olefin monomer which may be optionally chlorinated or fluorinated, polyester polymers, polycarbonate polymers, polymethacrylate polymers, cellulose acetate, polyester (e.g. biaxially oriented polyethylene terephthalate), vinyl acetates, and combinations thereof. Useful backings also include surface modified backings modified by, e. g., plasma discharge techniques including corona discharge treatment and flame treatment, mechanical roughening and chemical primers.

The guard conductor 1 comprises an electrically conductive material and preferably one or more metals which are applied as a layer or a film to one of the major surfaces of the backing layer 2. Especially preferably the guard conductor 1 comprises an aluminium layer. The guard conductor may be formed, for example, by a metal film which is bonded to such major surface of the backing layer 2 with an adhesive layer 3 such as, for example, a pressure-sensitive adhesive layer. The guard conductor 1 may also be directly applied to such major surface of the backing layer 2, for example, by vacuum metal vapour deposition.

The thickness of the guard conductor 1 may vary widely depending on the method of manufacturing it. A guard conductor layer 1 obtained by vacuum metal vapour deposition may be as thin as 200 - 800 Å and more preferably 300 - 500 Å. When using an aluminum foil as a guard layer 1 it may preferably have a thickness of from 1 -100 µm, more preferably 2 - 50 µm and especially preferably 3 - 30 µm.

The guard conductor 1 acts as a shield to reduce the sensitivity of the sensor conductor 7 to anything behind it in the direction of the body. In automotive applications, for example, it is desirable that the sensor conductor 7 detects objects that are generally outward of the vehicle but is effectively blind towards the inside of the vehicle.

Therefore the dimensions of the guard conductor 1 are preferably chosen to match at least those of the sensor conductor 7 but it is more preferred that the dimensions of the guard conductor 1 exceed at least partly those of the sensor conductor.

In an especially preferred embodiment the guard conductor 1 essentially fully covers the major side of the backing layer 2 it is attached to.

The sensor conductor 7 is arranged on the major surface, of the backing 2 which is opposite to the major surface being the guard conductor 1.

The sensor conductor 7 comprises an electrically conductive material and preferably one or more metals. In a preferred embodiment the sensor conductor 7 comprises a relatively cheap material such as an aluminium layer which may be applied by vacuum metal vapour deposition or as an aluminium film or foil which can be bonded to the backing 2, for example, by an adhesive layer such as, for example, a pressure-sensitive adhesive layer. In another preferred embodiment the sensor conductor 7 comprises a copper layer or plated copper layer as a conductive material which may be used, for example, in the form of optionally flattened wires which are applied to the backing layer, for example, by an adhesive layer 9. The sensor conductor may also comprise a copper layer which can be applied, for example, by vacuum metal vapour deposition or as an adhesively bonded copper film or foil.

The sensor conductor 7 may assume a variety of shapes and may exhibit a continuous or discontinuous configuration, respectively.

In automotive applications where the capacitive sensor film is attached, for example, to the rear side of a car, the sensor conductor may have the form of an elongated strip. In GB 2,348,505 it is disclosed that the sensor conductor 7 may be a strip comprising lobes at its two end regions in the longitudinal direction, i. e., the sensor conductor is wider at its end regions in the longitudinal direction than in its central portion. In use, the lobes are positioned at the ends of the bumper at the edges of a vehicle to provide a more uniform sensitivity profile along the width of the car.

In a preferred embodiment the sensor 7 conductor comprises a sequence of strips essentially extending in a longitudinal direction (i.e., for example, essentially along and parallel to the length of the backing layer 2). The strips may be formed by optionally flattened metal wires or strips of a metal foil. If the strips are arranged essentially parallel to each other another strip is preferably provided in a transverse direction to electrically connect the wires arranged in the longitudinal direction.

Sensor conductors 7 comprising a discontinuous arrangement of conductive areas such as an arrangement of optionally flattened wires whereby those areas are electrically connected, exhibit an especially advantageous sensitivity and are preferred.

The thickness of the sensor conductor 7 may vary widely depending on the method of manufacturing it. Sensor conductors comprising optionally flattened metal wires exhibit a thickness of typically between 20 and 200 µm and more preferably of between 25 and 100 µm. Sensor conductors 7 obtained by vacuum metal vapour deposition may be as thin as 200 - 800 Å and more preferably 300 - 500 Å. When using an aluminum foil as a sensor layer 7 it may have a thickness of from 1-100 µm, more preferably 2 - 50 µm and especially preferably 3 - 30 µm.

The capacitive sensor film 50 of the present invention may additionally comprise a superguard conductor 5 which is preferably arranged on the surface of the backing 2 bearing the sensor conductor 7. In automotive applications the superguard conductor 5 may be arranged - relative to the road level - above or below the sensor conductor. In use, an amplified guard signal may be applied to the superguard conductor 5 which has the effect of making the guard appear bigger. According to GB 2,374,422, this may be effective in automotive applications when the proximity sensor 50 is assembled, for example in the rear-side bumper of a car, to minimize the effect of water drips running down in rainy weather conditions across the bumper, on the signal of the sensor conductor 7.

The superguard conductor 5 comprises an electrically conductive material and preferably one or more metals. In a preferred embodiment the superguard conductor 5 comprises a relatively cheap material such as an aluminium layer which may be applied to the backing 2 as an aluminum film or foil, respectively, by means of, for example, an adhesive layer such as a pressure-sensitive adhesive layer. In another embodiment the superguard conductor 5 may comprise a metal layer such as an aluminum or copper layer applied to the backing layer 2 by vacuum metal vapour deposition. Alternatively it is also possible to apply the vacuum metal vapour deposit coating layer to a carrier film comprising, e. g., a polymer layer; the carrier film bearing the metal coating layer is then attached e. g. by means of an adhesive layer to the backing layer 2. In still another embodiment the superguard conductor may be discontinuous and formed, for example, by flattened metal wires which are attached to the backing layer 2, for example, by an adhesive layer.

The superguard conductor 5, if present, may assume a variety of shapes and can be continuous or discontinuous, respectively. In automotive applications where the capacitive sensor film 50 is assembled into the rear-side bumper of a vehicle, for example, the superguard conductor 5 may advantageously assume the form of an elongated strip extending along the rear-side bumper.

The thickness of the superguard conductor 5 may vary widely depending on the method of manufacturing it. Superguard conductor layers 5 obtained by vacuum metal deposition may be as thin as 200 - 800 Å and more preferably 300 - 500 Å. When using an aluminum foil as a superguard conductor layer 5 it may have a thickness of from 1-100 µm, more preferably 2 - 50 µm and especially preferably 3-30 µm.

The guard conductor 1, the sensor conductor 7 and, if present, the superguard conductor 5 of the capacitive sensor film 50 of the present invention are electrically contacted from one of the major surfaces 51, 52 of the filmor at the edge 53 of the laminate. The term edge 53 of the filmdenotes its circumferential extension in the direction of its thickness. The rear major surface 51 of the film50 may be formed by the exposed surface of the guard conductor or, if present, by the exposed surface of the rear protective layer 17. The front major surface 52 of the film50 may be formed by the front major surface 2b of the backing layer 2 or the exposed surfaces of the sensor conductor 7 or the superguard conductor 5, respectively, or, if present, by the exposed surface of the front protective layer 16. In a preferred embodiment the capacitive sensor film 50 of the present invention comprises at least one through-going hole 10 extending through the backing layer 2 to one of the major surfaces 51, 52 of the film 50. In case electrical connections are made to the capacitive sensor film 50 from its rear major surface 51, the sensor conductor 7 and, if present, the superguard conductor 5 may be contacted through such one or more through-going holes 10. Likewise, in case the film50 is electrically contacted from its front major surface 52, the guard conductor 1 may be contacted through such one or more through-going holes 10.

The one or more through-going holes 10 may be applied by any punching or die-cutting device such as, for example, by a pneumatic or mechanical hole punch, machined die or rotating block. The cross-section of the through-going holes 10 may have any shape including, for example, a circular, ellipsoidal, rectangular or irregular shape. The cross-sectional dimension of the through-going holes 10 is not critical and is selected to allow for a reliable electrical connection while not adversely affecting the integrity of the capacitive sensor laminate. Preferably the cross-sectional dimension of the through-going holes varies between 0.1 and 5 cm² and more preferably between 0.5 and 2.5 cm².

The one or more through-going holes 10 may be arranged inside or outside the area of the guard conductor 1, the sensor conductor 7 and/or - if present - the superguard conductor 5. If the through-going hole 10 is arranged, for example, inside the area of the sensor conductor 7 within a capacitive sensor film 50 which is electrically contacted from its rear surface 51, such through-going holes 10 may or may not extend through the sensor conductor 7. In a preferred embodiment the one or more through-going holes 10 extend to the rear surface of the sensor conductor 7 but do not extend through the sensor conductor 7. In this embodiment the rear surface of the sensor conductor 7 can be easily contacted through the one or more through-going holes 10 from the rear surface 51 of the laminate. In this embodiment it is alternatively also possible that the one or more through-going holes 10 extend through the sensor conductor 7 so that the front surface of the sensor conductor 7 can be contacted through the one or more through-going holes 10 from the rear side 51 of the laminate.

Likewise, if a superguard conductor 5 is present and the capacitive sensor film 50 is contacted from its rear side 51, such contact may be made through one or more further through-going holes which may end at the rear surface of the superguard conductor 5 or extend through the superguard conductor 5, respectively. It is also possible that the sensor conductor 7 and the superguard conductor 5 are contacted through one through-going hole 10,

If the capacitive sensor film 50 is contacted from its front surface 52 the one or more through-going holes 10 may likewise extend to the front surface of the guard conductor 1 or extend through the guard conductor 1, respectively.

It is, however, also possible that the one or more through-going holes 10 are arranged outside the area of the guard conductor 1, the sensor conductor 7 and/or - if present - the superguard conductor 5.

In a preferred embodiment of a capacitive sensor film 50 of the present invention which is electrically contacted from its rear side 51, the one or more through-going holes 10 are arranged outside the area of the sensor conductor 7 and/or the superguard conductor 5, if present.

In this case, one or more auxiliary conductors 12, 13 may be provided which are electrically connected to the sensor conductor 7 and, if present, to the superguard conductor 5. The auxiliary conductors 12, 13 may be formed, for example, by electrically conductive adhesive tapes comprising a backing bearing an electrically conductive adhesive. A strip of such tape is attached via its electrically conductive adhesive layer to the sensor conductor 7, and the length of such adhesive strip is selected so that it extends into the area of the through-going hole 10. Thus, the sensor conductor 7 can be electrically connected from the rear side 51 of the capacitive sensor film 50 via such auxiliary conductive adhesive strip. If the capacitive sensor filmadditionally comprises a superguard conductor 5, a separate auxiliary conductor 13 which may be an electrically conductive adhesive strip may be provided and electrically connected to the superguard conductor 5. Such strip extends into the area of the through-going hole 10 without contacting the adhesive strip 12 attached to the sensor conductor 7.

The auxiliary conductors 12, 13 may also be formed by metal foils or carrier films bearing a metal coating layer obtained, e. g., by vacuum metal vapour deposition. Such conductors 12, 13 are applied so that the metal foil or the metal coating layer contacts the sensor conductor 7 and, if present, the superguard conductor 5, and they may be held in place, for example, by conventional one-sided adhesive tapes.

The backing of an electrically conductive adhesive tape which can be used as auxiliary conductor 12, 13, may include electrically conductive and non-conductive materials such as metal films or polymeric films. Conductive film tapes comprising an aluminum or copper foil backing, respectively, bearing in each case an electrically conductive pressure-sensitive adhesive, are commercially available from 3M Company, St. Paul/MN, USA, under the trade designations "3M 1170 EMI Aluminium Foil Shielding Tape" and "3M 1181 EMI Copper Foil Shielding Tape", respectively. An aluminum foil having a thickness of 20 µm which can be used as a conductor 12, 13 is available, for example, from Tesco Comp. under the designation "cooking foil".

The conductor 12 may generally be formed by any material which can be attached to the sensor conductor 7 or, if present, to the superguard conductor 5 in an electrically connecting way and which is sufficiently self-supporting so that it provides a reliable electrical contact area within the area of the through-going hole 10. The conductor 12 may also be formed, for example, by an optionally flattened metal wire which is attached to the sensor conductor 7 and the superguard conductor 5 by means of an electrically conductive adhesive,

If desirable, an electrically insulating film 11 may be applied to fully cover the one or more through-going holes 10 on the front and/or rear side of the backing layer 2, respectively, before applying the conductors 12, 13. Such electrically insulating film comprises a backing which may be formed, for example, by any non-conductive polymeric or paper film. Useful non-conductive polymeric materials include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyvinylchloride, copolymers having a predominant olefin monomer which may optionally be chlorinated or fluorinated, polyester polymers, polycarbonate polymers, polymethacrylate polymers, cellulose acetate, polyester (e. g. biaxially oriented polyethylene terephthalate), vinyl acetates, and combinations thereof. The electrically insulating film preferably bears an adhesive layer 6 and, in particular, a pressure-sensitive adhesive layer on one of its major surfaces through which it is attached to the front and/or rear side of the capacitive sensor film 50. If the through-going holes 10 are arranged outside of the area of the sensor conductor 7 and, if present, the superguard conductor 5, such electrically insulating film may be applied to the front major surface of the backing film 2 and/or to the exposed surface of the guard conductor 1 so that it fully covers in each case the through-going hole 10. Then, holes are punched through the one or more electrically insulating films so that the through-going hole 10 is restored which now additionally extends through the insulating films. Preferably, the cross-sectional extension and/or shape of the holes punched into the electrically insulating films are selected so that the hole punched through the insulating film is smaller than the through-going hole punched originally. The edges of the electrically insulating films 11 extending into the area of the through-going hole 10, bond to the inner wall of the through-going hole 10 thereby electrically insulating the guard conductor 1 from the sensor conductor 7 and, if present, from the superguard conductor 5. In a preferred embodiment the length of the edges of the electrically insulating films 11 extending into the area of the through-going hole 10, is selected so that the inner wall of the through-going hole is essentially fully covered by the electrically insulating films 11. This specific design reliably insulates the guard conductor 1 from the sensor conductor 7 and, optionally, the superguard conductor 5 and additionally reinforces the area of the through-going hole 10. Electrically insulating films 11 are preferably applied both to the front major surface 2b of the backing film 2 and to the exposed surface of the guard conductor 1 of the through-going hole 10.

The above preferred embodiment has been described for the case that the capacitive sensor film 50 is contacted from its rear major surface 51.

It is, however, also possible that the capacitive sensor film 50 is contacted from its front major surface 52. In such case the one or more through-going holes 10 will extend from the front major surface 52 to the front surface of the guard conductor 1 or through the guard conductor to its rear surface, respectively. If the guard conductor does not fully cover the rear major surface 2a of the backing 2 and the one or more through-going holes are arranged outside the area of the guard conductor 1, one or more auxiliary conductors 12, 13 and, if desirable, one or more insulating films 11 may optionally be used as was described above to allow for an easy and reliable connection.

In another embodiment the film50 is electrically connected at its edge 53.

In a preferred embodiment the sensor conductor 7 comprises at least one area 21 and the guard conductor 1 comprises at least one area 22 with said areas 21, 22 being adjacent to each other and each being adjacent to the edge 53 of the filmor the edge 2c of the backing layer 2, respectively. The term "adjacent to the edge" means that such areas 21, 22 extend close to the edge 53 of the film50 or to the edge 2c of the backing layer so that such areas can be easily contacted, for example, by means of a socket 31 attached to the edge 53 of the film or the edge 2c of the backing layer, respectively. The shortest distance between the part of areas 21, 22 being electrically contacted and edge 53 or edge 2c, respectively, preferably is not more than 2 cm, more preferably less than 1 cm and especially preferably less than 5 mm. The term "adjacent to each other" means that the projections of such areas 21, 22 in a direction normal to the major surfaces 2a, 2b of the backing are so close to each other that connecting strips 33 contacting the sensor conductor 7 and the guard conductor 1 can be easily integrated into a socket 31. Preferably such projections of areas 21, 22 overlap with each other; the shortest distance between such projections preferably is not more than 1 cm and preferably less than 5 mm.

The areas 21, 22 should be large enough so that they can be reliably electrically connected to connecting strips 33. Preferably the areas 21, 22 are at least 0.01 mm², more preferably at least 0.04 mm² and especially preferably at least 0.1 mm².

If a superguard conductor 5 is present in such embodiment, it comprises at least one area 23 which is adjacent to the edge 53 of the capacitive sensor film 50 or the edge 2c of the backing film, respectively, and which is adjacent to the areas 21 and/or 22. The definitions for the terms "adjacent" given above apply correspondingly.

In some applications it is desirable to seal the capacitive sensor film 50 between protective films 16, 17 to protect the capacitive sensor film 50 against environmental impacts such as water or moisture, to electrically insulate the film50 and/or to render it more easily handleable. Such protective films are preferably selected from the group of polymeric films, layers and laminates. Useful polymers include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyester polymers, polycarbonate polymers, polymethacrylate polymers, cellulose acetate, polyester (e. g. biaxially oriented polyethylene terephthalate), vinyl acetates, and combinations thereof.

The protective polymer films may be applied to the front major surface 2a of the backing layer bearing the sensor conductor 7 and, optionally, the superguard conductor 5 and to the guard conductor 1 on the back major surface 2a of the backing 2 by adhesive means including, for example, hot-melt adhesives and pressure-sensitive adhesives. In another embodiment, the protective film may also be heat-laminated onto the front major surface 2b of the backing layer 2 and the guard conductor 1, respectively. The length and width of the protective films 16, 17 preferably exceed the length and width of the backing film 2 and/or the guard conductor 1 to provide an edge sealing to the capacitive sensor film 50 to protect, in particular, the edges of the guard conductor against corrosion. The length and width of the protective films 16, 17 is preferably selected to provide an edge sealing border with a width of 1 - 50 mm, more preferably of 1 - 40 mm and especially preferably of 2 - 20 mm. It is furthermore preferred, in particular, in automotive applications to include cuts and darts into the capacitive sensor film 50 so that the film can be better fitted to three-dimensional curvatures such as, for example, to the bumper inner skin. This allows the film 50 to lay essentially flat to the bumper inner skin without forming undesirable creases to an unacceptable degree. This applies to both edge-sealed films 50 comprise at least one protective film 16,17 and to non-edge-sealed films 50.

In case the capacitive sensor film 50 is contacted at one of its edges 53, the protective films 16, 17 may be removed in the areas 21, 22, 23 adjacent to the edge 53 subsequent to applying such films 16, 17. Alternatively, the protective films 16,17 may be approximately shaped prior to lamination so that the areas 21, 22, 23 are not covered by the protective film upon lamination.

In case the capacitive sensor film 50 is contacted via one or more through-going holes 10 these may be punched into the protective film 16, 17 on the major surface of the capacitive sensor film 50 from which the capacitive sensor film 50 is contacted thereby extending the through-going holes to such surface. In case the capacitive sensor film 50 is contacted from its rear major surface 51 a further hole may be punched into the protective film 17 to allow for contacting the guard conductor 1. Likewise, in case the capacitive sensor film 50 is contacted from its front major surface 52, one or more additional holes may be punched into the protective layer 16 to allow for contacting the sensor conductor 7 and, optionally, the superguard conductor 5 whereas the guard conductor 1 is contacted via one or more through-going holes 10.

Alternatively, one or more holes can be punched at appropriate locations into the protective film 16, 17 prior to lamination so that such pre-punched holes extend the through-going hole or holes 10 to the respective major surface of the capacitive sensor film 50 and/or provide access to the desired conductors 1, 7 and/or 5.

In case the capacitive sensor film 50 is contacted at one of its edges 53 connecting cables or strips are supplied into such edge region 53 and pressed against the guard conductor 1, the sensor conductor 7 and, optionally, the superguard conductor 5 to establish electrical contact. Pressure can be applied, for example, via spring loaded pads which continuously press on the connection areas between the conductors 1, 7, 5 and the connections strips 33.

Likewise, in the case the capacitive sensor film 50 if contacted from one of its major surfaces 51, 52, connecting cables or strips 33 are supplied through the one or more through-going holes 10 or through the additional holes which may be present to contact the guard conductor 1, the sensor conductor 7 and, optionally, the superguard conductor 5 and/or any auxiliary conductors 12, 13 which may be attached to conductors 1, 7 5. If the capacitive sensor film 50 is contacted, for example, from its rear major surface 51, connection strips 33 are supplied from the rear side 51 of the capacitive sensor film 50 through the one or more through-going holes 10 and pressed against the sensor conductor 7, the superguard conductor 5 and/or the auxiliary conductors 12, 13, respectively to establish electrical contact. Pressure can be applied, for example, via spring loaded pads which continuosly press on the connection areas between the connectors and the sensor conductor 7, the superguard conductor 5 and/or the auxiliary conductors 12, 13, respectively.

In a preferred embodiment, the one or more through-going holes 10 may be filled with a conductive ink such as a silver ink which is subsequently solidified by evaporative drying or curing. The through-going hole 10 may also be filled, for example, with a precursor of a silver epoxy adhesive which is thermally cured upon insertion into the one or more through-going holes 10. In these constructions the connecting strips 33 do not need to be supplied through the through-going holes 10 but can be applied, for example, at the respective major surface 51, 52 of the capacitive sensor film 50. Establishing of electrical contact between the connectors and the sensor conductor 7, the superguard conductor 5 and/or the conductors 12, 13 is thus facilitated, and the resulting connection is more reliable and mechanically stable.

The capacitive sensor film 50 of the present invention can thus easily and reliably be electrically contacted from one of its major surfaces 51, 52 or from its edge 53 or from the edge 2c of the backing layer, respectively. Contacting the capacitive sensor film 50 from one of its major surfaces 51, 52 and, in particular, from its rear major surface 51 is particularly preferred in automotive applications.

It is usually desirable to integrate the connectors contacting the guard conductor 1, the sensor conductor 7 and, optionally, the superguard conductor 5 and/or the conductors 12, 13 in a socket body 31 which may be applied to the capacitive sensor film 50 to allow for a standardized connection. When applied to one of the major surfaces 51, 52 or to the edge 53 of the capacitive sensor film 50 respectively, a complete hermetic seal is preferably formed between the periphery of the socket body 31 and the capacitive sensor film 50 or thus preventing water, air or dust ingress into the inner layers or the connection area. In a preferred embodiment the socket body 31 comprises sealing means such as sealing O rings 32 around its periphery contacting the capacitive sensor film 50. The socket body 31 is applied to the capacitive sensor film 50 so that the sealing O rings are pressurized and form the required hermetic seal.

The capacitive sensor film 50 of the present invention may be advantageously used in automotive applications for sensing the proximity of a car to other objects where it can be introduced, for example, in the rear and front bumper. The capacitive sensor film 50 can be cut into the required shape by any die-cutting, punching or laser cutting means, for example. Due to its flexibility it can be easily processed and bent into conformity with the bumper shape, if required. It is particular advantageous that the capacitive sensor film 50 can be easily electronically connected from its rear side which does not only facilitate assembling at the OEM (original equipment manufacturer) site but also allows, for example, for an easy replacement of such capacitive sensor film 50 if the bumper incorporating it is damaged in an accident.

The capacitive sensor films 50 of the present invention can be easily installed and they are flexible so that they can be applied to shaped substrates having, for example, curved surfaces. It is particularly advantageous that the capacitive sensor films 50 can be electrically contacted in an easy and reliable way. In view of these advantages the capacitive sensor films 50 of the present invention are especially suited for use in the automotive industry.

Devices which are suitable for measuring and processing signals of the sensor conductor 7 have been disclosed, for example, in WO 02/19,524 and are not further described here.

In a preferred method of manufacturing a capacitive sensor film 50 of the present invention which may be contacted from one of its major surfaces 51, 52, an aluminum film laminate comprising the backing layer 2 bearing an aluminum layer which forms the guard conductor 1, is provided first. The sensor conductor 7 and the superguard conductor 5, if present, may be metal films or foils which are applied to the other major surface of the backing layer 2 which is opposite to the guard layer 1, for example, by adhesive means. Alternatively, the sensor conductor 7 and the superguard conductor 5, if present, may also be applied by vacuum metal vapour coating.

Then the one or more through-going holes 10 are applied to the backing layer 2. If the capacitive sensor film 50 is to be contacted, for example, from its rear major surface 51 and if the one or more through-going holes are to extend in the area of the sensor conductor 7 and, optionally, the superguard conductor 5, such through-going holes 10 may be punched in from the rear major surface 51 so that they extend to the rear surface of the conductors 7, 5 facing the backing layer 2. Alternatively the through-going holes 10 may be punched into the backing layer 2 and the guard conductor 1 first, and the sensor conductor 7 and, if present, the superguard conductor 5 are applied subsequently. In another embodiment the one or more through-going holes 10 may extend through the sensor conductor 7 and, if present, the superguard conductor 5.

If the capacitive sensor film 50 is to be contacted, for example, from its rear major surface 51 but if the through-going holes 10 are applied outside of the area of the sensor conductor 7 and the superguard conductor 5, auxiliary conductors 12, 13 may be applied so that they are electrically connected to the sensor conductor 7 and, if present, to the superguard conductor 5. The auxiliary conductors 12, 13 extend into the area of the one or more through-goings holes 10 and can be contacted from the rear major surface 51 of the laminate.

If the capacitive sensor film 50 is to be contacted from its front major surface 52, one or more through-going holes are applied analogously to the embodiments described above to allow for contacting the guard conductor 1. The one or more through-going holes typically extend in the area of the guard conductor 1 which preferably covers at least the major part of the rear major surface 2a of the backing layer 2. The through-going holes 10 may extend to the front surface of the guard conductor 1 facing the backing layer 2, or they may also extend through the guard conductor 1. In the latter case auxiliary conductors 12, 13 may be used to facilitate providing of electrical connections.

In a preferred embodiment protective layers 16, 17 are sealed to the capacitive sensor film 50, for example, by heat lamination or by means of a hot melt adhesive. One or more holes to be arranged above the one or more through-going holes 10 and/or in case the film 50 is contacted, for example, from its rear major surface, above the guard conductor 1 may be punched into the protective films 16, 17 prior to applying them.

Alternatively, such hole or holes may be applied subsequently to sealing the protective films 16, 17 to the capacitive sensor film 50.

The capacitive sensor film 50 is preferably manufactured continuously. In such case the capacitive sensor film 50 is cut from the continuous web.

The capacitive sensor film 50 is trimmed into the required shape, for example, by die-cutting, laser cutting or a V knife on an XY table cutter. Then the electrical contact is provided from one of the major surfaces 51, 52 of the film through the one or more through-going holes 10, for example, by means of pressure contact. Contacting may be facilitated by filling the through-going holes 10 with a conductive fluid, such as, for example, a silver ink or a silver epoxy adhesive which may be subsequently cured or heat-dried. If the capacitive sensor film 50 is electrically connected from its rear major surface 51, contact can be made through the through-going holes 10 to the sensor conductor 7 and, optionally, the superguard conductor 5. The guard conductor 1 can be contacted in this embodiment, for example, by a further hole punched into the rear protective layer 17.

If desirable, connection to the guard conductor 1, the sensor conductor 7 and the superguard conductor 5, if present, may be made by applying a suitably designed socket 31.

In another preferred method of manufacturing a capacitive sensor film 50 of the present invention which may be contacted from its edge 53 or from the edge 2c of the backing layer 2, respectively, a backing layer 2 is provided first. Then the guard conductor 1 is applied to the rear major surface 2a of the backing layer so that it comprises at least one area 22 which is adjacent to the edge 2c of the backing layer 2. Likewise, a sensor conductor 7 and, optionally, a superguard conductor 5 is applied to the front major surface 2b of the backing layer 2 so that the sensor conductor 7 comprises at least one area 21 and the superguard conductor 5 comprises at least one area 23 which are adjacent to the edge of the backing layer 2 and adjacent to each other and to the area 21. The meaning of the term "adjacent" given above applies here as well.

In a preferred embodiment protective layers 16, 17 are sealed to the film 50, for example, by heat lamination or by means of a hot melt adhesive. The protective layers 16, 17 are preferably appropriately shaped prior to lamination so that areas 21, 22, 23 are not covered by the protective layers 16, 17 subsequent to lamination. Alternatively it is also possible to remove the parts of the protective layers 16, 17 covering the areas 21, 22, 23 subsequent to lamination.

The protective films 16, 17 are usually larger than the backing layer 2 so that the protective film 16,17 provide for an edge sealing.

These preferred methods of manufacturing are highly advantageous because they can be operated continuously or semi-continuously, and they can also be included in the manufacturing lines of automobiles, for example.

### Detailed description of the figures

The following figures are schematic and are not drawn to scale.

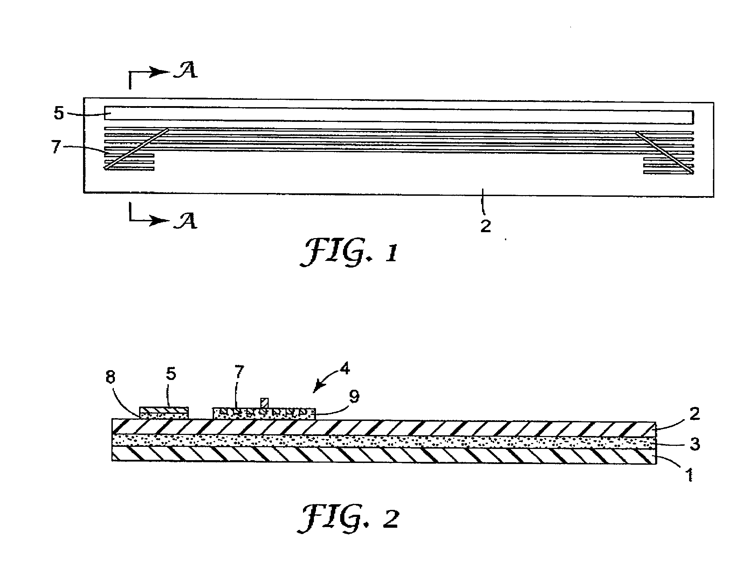

*Fig. 1* shows a top view of a precursor of the capacitive sensor film 50 of the present invention comprising a backing layer 2 bearing a sensor conductor 7 arranged in the sensor area 4 and a superguard conductor 5. The sensor conductor 7 exhibits a discontinuous design and is composed of several optionally flattened metal wires extending in parallel to the long side of the backing layer 2, i.e. in a longitudinal direction. At both ends the sensor conductor 7 comprises additional shorter pieces of such wire to provide lobe type end regions in order to increase the sensitivity of the sensor conductor 7 at its end regions. The different wires of the sensor conductor 7 are connected at both end regions by two wires extending each transversely inclined to the direction of the long side of the backing layer 2. The superguard conductor 5 is formed by a thin metal strip extending in parallel to the long side of the backing layer 2.

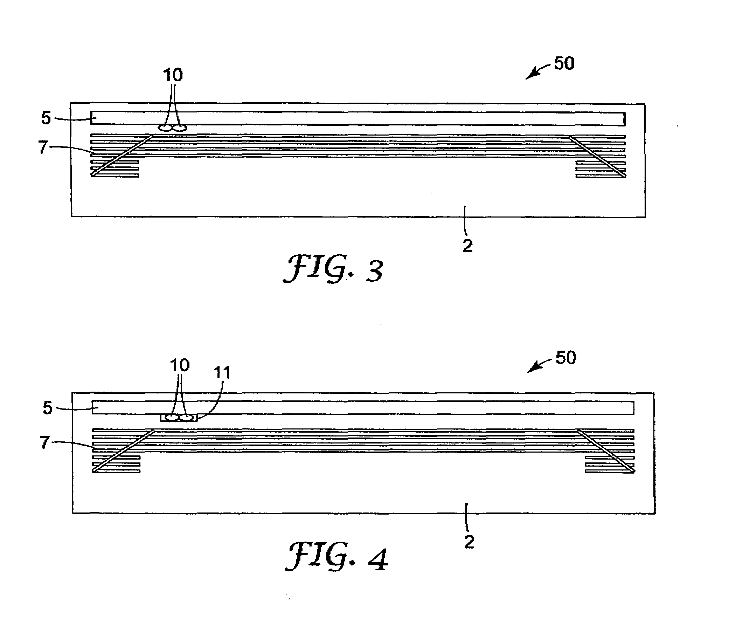

*Fig. 2* is a cross-sectional view of the precursor film of Fig. 1 along the line A-A indicated in Fig. 1. The guard layer 1 extends all along the width of the backing layer 2 and is attached to it by means of the adhesive layer 3. The superguard conductor 5 and the wires forming the sensors conductor 7 are attached by the adhesive layers 8, 9 to the front major surface of the backing layer 2 which is opposite to the guard layer 1. The metal wires or metal strips of the sensor conductor 7 are embedded into adhesive layer 9 but it is also possible, for example, that the metal wires or metal strips are each attached by small adhesive spots. The small square residing on top of the wires or strips embedded in the adhesive layer corresponds to the transversely inclined wire or strip connecting the embedded wires or strips.
Fig. *3* is a top view of a capacitive sensor film 50 of the present invention obtained from the precursor of Fig. 1 by applying two through-going holes 10 in the area between the superguard conductor 5 and the sensor conductor 7.
*Fig. 4* is a top view of the capacitive sensor film 50 of Fig. 3 where an electrically insulating film 11 has been applied to the front surface of the backing layer 2 so that it covers the two through-going holes 10 initially created. Subsequently, holes have been punched into the insulating film 11 to restore the through-going hole 10. The holes punched into the insulating film 11 are smaller than the through-holes 10 created initially.

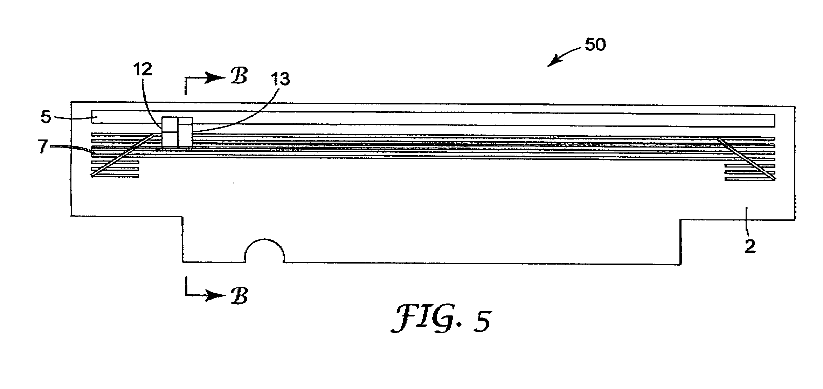

*Fig. 5* is a top view of the capacitive sensor film 50 of Figs. 3 and 4 where auxiliary conductors 12, 13 have been applied extending from the superguard conductor 5 and the sensor conductor 7, respectively, into the area of the respective through-going hole 10. The capacitive sensor film has already been cut into the shape required for its insertion into a car bumper.

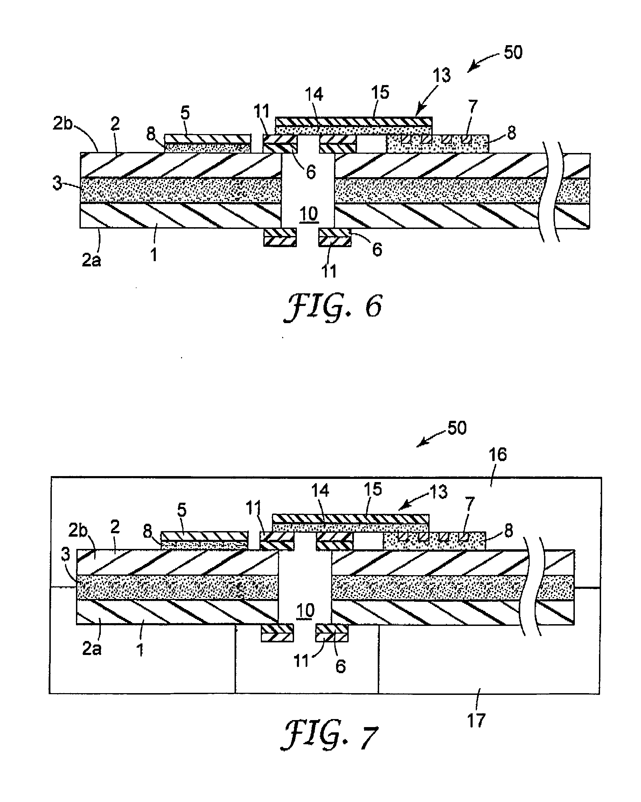

*Fig. 6* is a cross-sectional view of the capacitive sensor film 50 of Fig. 5 along the line B-B indicated in Fig. 5. It can be seen that the insulating film 11 has been applied to both the front and rear side of the capacitive sensor film 50, and that holes have been punched into such insulating film 11 which are smaller than the through-going hole 10 initially created. The insulating film 11 comprises a backing (which is no designated in Fig. 6 by a referral number) and an adhesive layer 6 which holds the insulating film 11 in place. The auxiliary conductor 13 comprising a backing 15 and an electrically conducting adhesive layer 14 is attached to the sensor conductor 7 and extends over the through-going hole 10 to the insulating film 11 on the opposite side of the hole. It can be seen that the sensor conductor 7 is electrically connectable via the through-going hole 10 from the rear side of the capacitive sensor film 50.

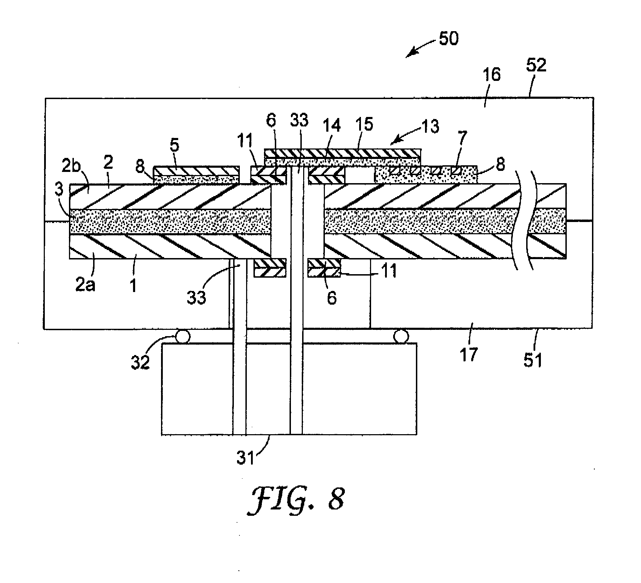

*Fig. 7* and Fig. 8 are cross-sectionals view of the capacitive sensor film 50 of Fig. 5 along the line B-B of Fig. 5 additionally comprising protective layers 16, 17 sealed to both the front and rear major surface 2a, 2b of the backing 2 by means of a hot-melt adhesive 18 (not shown). A hole has been cut into the protective layer 17 applied to the rear major surface 2a of the backing layer 2 in order to extend the through-going hole 10 to the rear surface of the protective layer 17. The width of the through-going hole 10 in the protective layer 17 exceeds the width of the through-going hole 10 in the backing layer so that the connecting strips 33 contacting the guard conductor 1, the sensor conductor 7 and the superguard conductor 5 can be integrated into a socket housing 31. This is shown in Fig. 8 which is a cross-sectional view of the capacitive sensor film 50 of Fig. 5 along line B-B wherein the capacitive sensor film additionally comprises a socket 31 which is applied to the rear major surface 51 of the capacitive sensor film 50 50. The guard conductor 1 and the connector 13 (which is electrically connected to the sensor conductor 7) are connected to connecting strips 33 which are fed into the socket 31. The socket 31 comprises O sealing rings 32 which are pressurized and form a hermetic seal. A gasket of adhesive may be used instead of the O sealing ring.

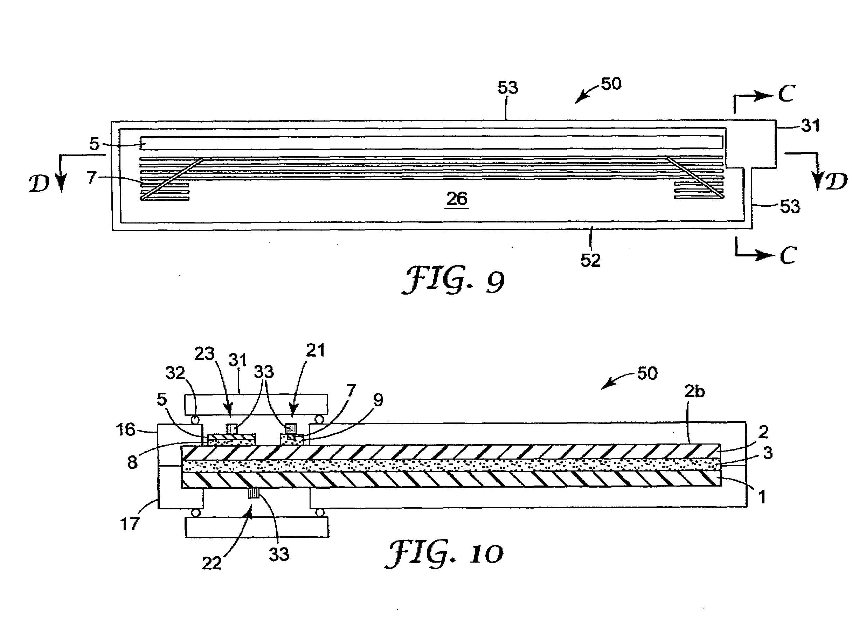

Fig. 9 is a top view of another preferred embodiment of the capacitive sensor film 50 of the present invention showing the front major surface 52 of the film 50 which is provided by the front surface of the protective layer 16, The protective layer is applied to and covers the front major surface 2b of the backing layer 2 bearing the sensor conductor 7 and the superguard conductor 5. The sensor conductor 7 exhibits a discontinuous design and is composed of several optionally flattened metal wires extending in parallel to the long side of the backing layer 2, i. e. in a longitudinal direction. At both ends the sensor conductor 7 comprises additional shorter pieces of such wire to provide lobe type end regions in order to increase the sensitivity of the sensor conductor 7 at its end regions. The different wires of the sensor conductor 7 are connected at both end regions by two wires extending each transversely inclined to the direction of the long side of the backing layer 2. The superguard conductor 5 is formed by a thin metal strip extending in parallel to the long side of the backing layer 2. A socket 31 is attached at the edge 53 of the capacitive sensor film 50.
Fig. 10 is a cross-sectional view of the capacitive sensor film 50 of Fig. 9 along the line C-C indicated in Fig. 9. The guard layer 1 extends all along the width of the backing layer 2 and is attached to it by means of the adhesive layer 3. The superguard conductor 5 and one of the wires forming the sensor conductor 7 are essentially extended to the edge of the backing 2 and can therefore be seen in the cross-sectional view of Fig. 10. The superguard conductor 5 and the wire of the sensor conductor 7 are attached by the adhesive layers 8, 9 to the front major surface 2b of the backing layer 2. The protective layers 16, 17 are removed in the areas 21, 22, 23 where the socket 31 is applied and where connecting strips 33 are connected to the guard conductor 1, the sensor conductor 7 and the superguard conductor 5. The socket 31 comprises O sealing rings 32. A gasket of adhesive may be used instead of the O sealing ring.

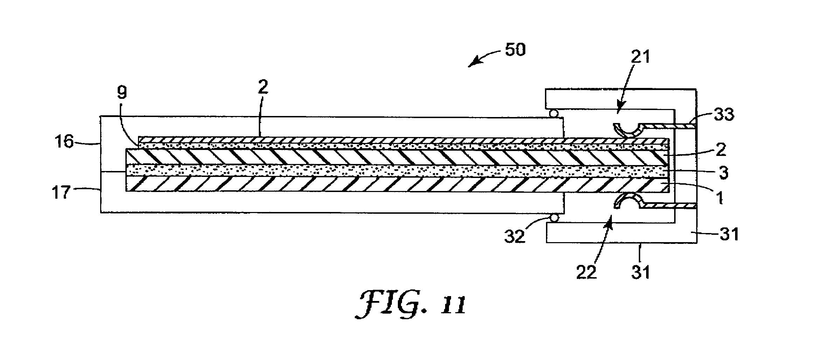

Fig. 11 is a cross-sectional view of the film50 of Fig. 9 along the line D-D indicated in Fig. 9. The cross-sectional view shows the wire of the sensor conductor extending to the edge of the backing layer 2. Such wire is attached with the adhesive layer 9 to the front major surface 2b of the backing layer 2. The protective layer 16 has been removed in the edge area 21 where the wire of the sensor conductor 7 extends to the edge 2c of the backing layer 2. The protective layer 17 was likewise removed in the edge area 22 which is opposite to the area 21; in this area the guard conductor extends to the edge of the backing layer 2. The socket 31 is applied to the film50 in such edge areas 21, 22 providing two connecting strips 33 which form pressure contact with the area 21 of the guard conductor 1 and the area 22 of the sensor conductor (where a wire of the sensor conductor 7 is extended essentially to the edge 2c of the backing layer 2), respectively.

The present invention is further illustrated in the following non-limiting Examples.

### Examples

### Example 1

A conventional aluminum foil (thickness 20 µm) which is available from Tesco Comp., UK, as a cooking foil was laminated to a 100 µm polyethyleneterephthalate (PET) film bearing a 25 µm ethylenevinylacetate (EVA) adhesive layer. The PET film bearing the adhesive layer was available from GBC, UK. The lamination was performed at a temperature of about 110°C using an office type laminator. The aluminum layer acted as the guard layer.

On the major side of the PET film opposite to the aluminum guard layer a 12 mm wide aluminum foil tape available from 3M Company under the designation "3M Aluminum Foil Tape 425" was applied along the whole length of the PET film. This aluminum strip tape acted as a superguard layer. Then a double-sided adhesive tape (available from 3M Company under the designation 9512 was applied to the major surface of the backing layer opposite to the guard layer and next to the superguard layer. A sequence of flattened copper wires (tin plated copper wires, 50 µm thick and 0.5 mm wide, available from Chaplin Bros, Birmingham, UK) which extended along the length of the PET film was applied to the exposed surface of the double-sided adhesive tape. The wires were each parallel to the long side of the PET film (I.e. extended in a longitudinal direction) and spaced 5 mm apart. The wires arranged in parallel in such longitudinal direction were electrically connected to each other by another flattened copper wire extending in a transversely inclined direction with respect to the longitudinal direction. This discontinuous arrangement of flattened wires formed the sensor conductor.

Then, connector holes were punched in the area of the backing layer between the guard conductor and the superguard conductor through the backing layer and the guard conductor using engineer's hole punch.

Then a polyester film pressure sensitive adhesive tape (8417, available from 3M) was applied to the front major surface of the backing layer and the exposed surface of the guard layer, respectively, so that the through-going hole was covered on the front and rear side of the backing layer. Then a hole, smaller than the original one was cut through the polyester films, in order to obtain an isolating ring. Aluminium foil tape (Al tape 1170, available from 3M) and copper foil tape (Copper foil tape: Cu tape 1181, available from 3M) were applied. A strip of a laminate formed of aluminium foil conductive adhesive tape 1170, 5 mm wide and a 25 mm wide piece of polyester tape 8417 was electrically connected to the sensor conductor so that the opposite end extended into the area of one of the through-going hole. A strip of a laminate of copper foil conductive adhesive tape 1181, 5 mm wide on a 25 mm wide piece of polyester tape 8417 was electrically connected to the superguard conductor so that the opposite end extended into the area of the other through-going hole. The laminate strips were applied such that there was a 5 mm gap between the two conductive tape strips.

The capacitive sensor filmthus obtained was then laminated between two pieces of heat seal protective polyester film (50 µ PET film with 25µ EVA heat seal adhesive, available from GBC, UK). Appropriate holes were cut into the protective polyester film applied to those areas of the rear side of the capacitive sensor filmcovering the through-going holes.

Finally, a conductive silver ink obtainable from Sun Chemicals was filled into the through-going holes and dried. Then a socket body was applied. The capacitive sensor filmwas then trimmed to shape and the connector applied to make the electrical contacts.

### Example 2

Example 1 was repeated using a 6.35 µm thick aluminum foil obtainable from Alcan, UK, which was laminated to a 80 µm thick filled polypropylene film obtainable from RKW, Sweden, under the trade designation FPO bearing a 20 µm ethylene vinylacetate adhesive layer. The FPO film is a blown film comprising calcium carbonate and talc particles which are bound in a polypropylene matrix. The aluminum foil was laminated to the adhesive layer on the FPO film at a temperature of 90°C using an office type laminator.

Then the sensor conductor the the superguard conductor were applied and the through-going holes were provided, covered with 8417 tape and punched through to provide holes smaller than the original through-going hole as was described in Example 1.

Then a strip of a laminate formed of a 5 mm wide strip of an aluminum foil (20 µm thick, available from Tesco Comp., UK, as cooking foil) and of a 25 mm wide strip of polyester tape 8417 were electrically connected to each of the sensor conductor and the superguard conductor, respectively, so that the opposite end extended into the area of one of the through-going holes each. The other details were selected as described in Example 1.

The resulting capacitive sensor filmwas laminated between two heat and protective FPO films (60 µm thick with a 25 µm EVA layer) as was described in Example 1. Connections were made by pressure contact by forming a cross cut through each connection area, pushing through a small machine screw, applying a washer and a nut to the guard conductor side and tightening down to form an electrical contact with the sensor conductor and the superguard conductors, respectively.

### Example 3

Example 1 was repeated but an aluminized film comprising a 12 µm PET film bearing a 300-500 A aluminium vapour coat (available from Amcor, UK) laminated to an FPO film as in Example 2 was used instead of the laminate of the Al foil and the PET film.

List of reference numbers
- 1: guard conductor
- 2: backing layer
- 2a: rear major surface of the backing layer 2
- 2b: front major surface of the backing layer 2
- 2c: edge of the backing layer 2
- 3: adhesive layer
- 4: sensor area
- 5: superguard conductor
- 6: adhesive layer
- 7: sensor conductor
- 8: adhesive layer
- 9: adhesive layer
- 10: through-going hole
- 11: electrically insulating film
- 12, 13: auxiliary conductor
- 14: electrically conducting adhesive layer
- 15: backing layer
- 16: front protective layer
- 17: rear protective layer
- 21: area of guard conductor 1 adjacent to edge 53 or 2c, and to areas 22, 23
- 22: area of sensor conductor 7 adjacent to edges 53 or 2c and to areas 21, 23
- 23: area of superguard conductor 5 adjacent to edges 53 or 2c and to areas 21, 22
- 31: socket
- 32: O sealing ring
- 33: connecting strip
- 50: capacitive sensor film
- 51: rear major surface of the film 50
- 52: front major surface of the film 50
- 53: edge of the film 50

## Claims

1. A capacitive sensor film (50) for mounting to a body having a rear major surface (51), a front major surface (52) and an edge (53), said filmcomprising a backing layer (2) having a rear major surface (2a) facing, in use, the body and a front major surface (2b) opposite to said rear major surface (2a), said rear major surface (2a) bearing a guard conductor (1) and said front major surface (2b) bearing a sensor conductor (7) wherein electrical contact can be made to the sensor conductor (7) and to the guard conductor (1) from one of the major surfaces (51, 52) of the capacitive sensor film (50) or, at the edge (53) of the capacitive sensor film (50) or at the edge (2c) of the backing layer (2), respectively.

2. Capacitive sensor film according to claim 1 wherein said front major surface (2b) additionally bears a superguard conductor (5) wherein electrical contact can be made to the superguard guard conductor (5) from the major surfaces (51, 52), at the edge (53) of the film (50) or at the edge (2c) of the backing layer (2), respectively, from which the guard conductor (1) and the sensor conductor (7) can be contacted.

3. Capacitive sensor film according to any of claims 1 - 2 wherein the guard conductor (1), the sensor conductor (7) and, if present, the superguard conductor (5) are provided with electrical connectors (33) so that such connectors (33) can be fed into a socket (31) which is arranged on one major surface (51,52) of the film(50) or at the edge (53) of the film (50) or at the edge (2c) of the backing layer (2), respectively.

4. Capacitive sensor film according to any of the preceding claims comprising one or more protective layers (16,17) applied to the rear major surface (2a) of the backing layer (2) and/or on the front surface (2a) of the backing layer (2).

5. Capacitive sensor film according to claim 4 wherein the extension of the protective layers exceeds the extension of the backing layer (2) in both the length and the width direction of the film(50) so that the protective layers (16,17) are laminated against each other around the edge (53) of the film(50) thereby forming an edge sealing.

6. Capacitive sensor film according to any of claims 1 - 5 comprising at least one through-going hole (10) extending through the backing layer (2) to one of the major surfaces (51, 52) of the capacitive sensor film (50).

7. Capacitive sensor film according to claim 6 wherein said one or more through-going holes (10) are arranged so that they do not extend through the area of said sensor conductor (7).

8. Capacitive sensor film (50) according to claim 7 where an auxiliary connector (13) is electrically connected to the sensor conductor (7) and extends essentially parallel to the front major surface (2b) of the backing layer (2) so as to at least partly cover the through-going hole (10).

9. Capacitive sensor film (50) according to claims 1-5 wherein said sensor conductor (7) comprises at least one area (21) and the guard conductor (1) comprises at least one area (22), said areas (21), (22) being adjacent to the edge (2c) of the backing layer (2) or the edge (53) of the film(50), and adjacent to each other.

10. Capacity sensor film (50) according to claim 9 wherein said front surface additionally bears a superguard conductor (5) comprising at least one area (23) being adjacent to the edge (2c) of the backing layer (2) or the edge (53) of the film(50), respectively, and being adjacent to the areas (21), (22).

11. Capacity sensor film according to any of the preceding claims wherein the sensor conductor (7) is a metal film bonded to the front surface of the backing layer (2) with an adhesive layer or is applied to the front surface of the backing layer (2) by metal vapour coating.

12. Capacity sensor film according to any of the preceding claims wherein the sensor conductor (7) is an electrically conductive film or pattern comprising a conductive ink.

13. Capacitive sensor film according to any of the preceding claims wherein the sensor conductor (7) forms a continuous or discontinuous metal area or areas whereby the discontinuous areas are electrically connected.

14. Capacitive sensor film according to claim 13 wherein the sensor conductor (7) comprises at least one elongated strip.

15. Capacitive sensor film according to claim 14 wherein the sensor conductor (7) comprises two or more separate elongated strips which are electrically connected.

16. Capacitive sensor film according to claim 15 wherein the two or more elongated strips are formed by metal wires adhesively bonded to the front surface of the backing layer (2).

17. Capacitive sensor film according to any of the preceding claims wherein the sensor conductor has a non-uniform width along its length.

18. Capacitive sensor film according to any of the preceding claims wherein the guard conductor (1) is a metal film bonded to the rear surface of the backing layer (2) with an adhesive layer (3) or is applied to the rear surface of the backing layer (2) by metal vapour coating.

19. Capacitive sensor film according to any of the preceding claims wherein the area of the guard conductor (1) is selected to shield the sensor conductor (7) and, if present, the superguard conductor (5).

20. Method of manufacturing a capacitive sensor film according to claims 6 - 8 and 11 -19 comprising
(iv) providing a backing layer (2) comprising a rear major surface (2a) and a front major surface (2b),
(v) applying a guard conductor (1) to the rear major surface (2a) of the backing layer (2),
(vi) applying a sensor conductor (7) to the front major surface (2b) of the backing layer (2),
(iv) providing one or more through-going hole or holes (10) extending through the backing layer (2) so that the guard conductor (1), the sensor conductor (7) and optionally the superguard conductor (5) can be electrically contacted from one major surface (51, 52) of the laminate.

21. Method of manufacturing a capacitive sensor film according to claims 9 -19 comprising
(i) providing a backing layer (2),
(ii) applying a guard conductor (1) to the rear major surface of the backing layer (2) so that the guard conductor (1) comprises at least one area (22) being adjacent to the edge (53) of the film(50), and
(iii) applying a sensor conductor (7) to the front major surface (2b) of the backing layer (2) so that the sensor conductor (7) comprises at least one area (21) being adjacent to said area 822) and to the edge (53) of the film(50) so that electrical contact can be made to the guard conductor (1) and the sensor conductor (7) at the edge of the capacitive sensor laminate.
